# EUROPÄISCHE PATENTSCHRIFT

(11) **EP 1 946 438 B1**
(45) Veröffentlichungstag und Bekanntmachung des Hinweises auf die Patenterteilung: **31.07.2013**
(21) Anmeldenummer: 06828927.1
(22) Anmeldetag: 06.11.2006
(51) Int. Cl.: H03D 7/16, H03C 3/40

(54) **SCHALTUNG ZUR SIGNALAUFBEREITUNG MIT GEMEINSAMEN OSZILLATOR**
SIGNAL CONDITIONING CIRCUIT WITH A SHARED OSCILLATOR
CIRCUIT DE REGENERATION DE SIGNAUX AVEC OSCILLATEUR COMMUN

(30) Priorität: 10.11.2005 DE 102005053723
(43) Veröffentlichungstag der Anmeldung: 23.07.2008
(73) Patentinhaber: Rohde & Schwarz GmbH & Co. KG, 81671 München (DE)
(72) Erfinder: ROTH, Martin, 82319 Starnberg (DE); JELEN, Mattias, 80805 München (DE); HOLZMANN, Gottfried, 85604 Zorneding (DE); MOSER, Albert, 81825 München (DE); OETJEN, Martin, 82194 Gröbenzell (DE)
(74) Vertreter: Körfer, Thomas
(86) Internationale Anmeldenummer: PCT/EP2006/010611
(87) Internationale Veröffentlichungsnummer: WO 2007/054253

(56) Entgegenhaltungen:
- WO-A-97/08567
- WO-A-03/007564
- WO-A2-02/29985
- GB-A- 2 310 342
- GB-A- 2 337 169
- US-A- 4 926 130
- US-A- 5 717 719
- US-A- 5 784 413
- US-A1- 2002 138 854
- US-B1- 6 345 177

## Beschreibung

Die Erfindung betrifft eine Schaltung zur Signalaufbereitung in mehreren Stufen mit gemeinsamen Oszillator zur Minimierung des Rauschens.

Bei der mehrstufigen Signalaufbereitung, beispielsweise bestehend aus einem Digital/Analog-Wandler, einem I/Q-Modulator und mehreren Mischern, wird das Signal/RauschVerhältnis an jeder Stufe verschlechtert. Ein wesentliches Problem dabei ist, dass die den einzelnen Stufen zugeordneten Oszillatoren unabhängig voneinander realisiert werden. Folglich sind die Phasenfluktuationen der einzelnen Oszillatoren und Taktgeneratoren völlig unkorreliert zueinander, so dass durch diese mangelnde Korrelation das Gesamtrauschen ansteigt.

Aus der WO 03/007564 A geht eine Schaltung zur Signalaufbereitung bestehend aus einer ersten Stufe mit einem digital/analog-Wandler und einer zweiten Stufe mit einem I/Q-Modulator hervor.

Aus Der GB 2 310 342 A geht ebenfalls ein mehrstufiges Sendersystem hervor, das in einer dritten Stufe einen Mischer aufweist.

Aufgabe der Erfindung ist es, das Phasenrauschen in einer Schaltung zur mehrstufigen Signalaufbereitung zu minimieren.

Die Aufgabe wird durch den einzigen Patentanspruch 1 gelöst.

Erfindungsgemäß wird in einer mehrstufigen Schaltung zur Signalaufbereitung mit einem Digital/Analog-Wandler, einem I/Q-Modulator und zumindest einem Mischer statt einer Vielfachheit von Oszillatoren für die einzelnen Stufen ein einzelner gemeinsamer Oszillator verwendet.

Damit sind die Phasenfluktuationen korreliert zueinander, so dass durch diese Korrelation das Gesamtrauschen absinkt.

Anhand der Zeichnung wird nachfolgend ein Ausführungsbeispiel der Erfindung beschrieben. In der Zeichnung zeigen:
- Fig. 1: eine Schaltungsanordnung zur mehrstufigen Signalaufbereitung gemäß dem Stand der Technik;
- Fig. 2: eine Schaltungsanordnung zur mehrstufigen Signalaufbereitung gemäß der Erfindung;
- Fig. 3: einen im Rahmen der Erfindung verwendbaren I/Q-Modulator und
- Fig. 4: einen im Rahmen der Erfindung verwendbaren Frequenzsynthesizer.

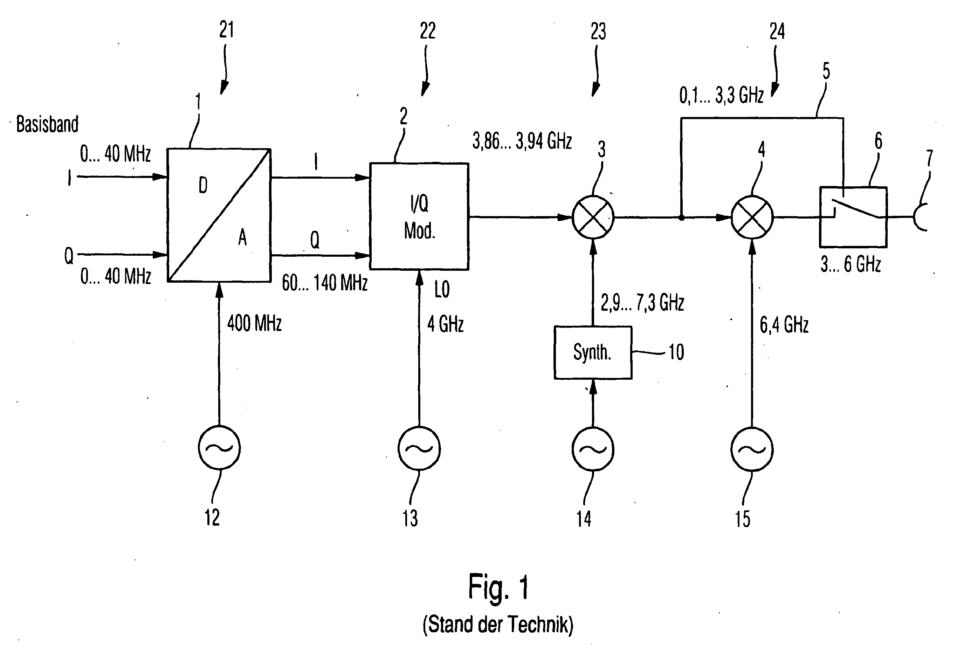

Die Schaltungsanordnung in Fig. 1 gemäß dem Stand der Technik umfasst mehrere Signalverarbeitungsstufen, wobei die Stufen durch einen Digital/Analog-Wandler 1, einen I/Q-Modulator 2, die Mischer 3 und 4, sowie einen Umschalter 5 ausgebildet werden.

Dem Digital/Analog-Wandler 1 werden über zwei Zuleitungen die Inphase (I)- und Quadratur (Q)-Komponente eines digitalen Basisbandsignals zugeführt. An einem dritten Eingang wird dem Digital/Analog-Wandler 1 ein Taktsignal zugeführt, welches von einem ersten Oszillator 12 abgeleitet wird. Das gewandelte, analoge Signal wird in seinen I- und Q-Komponenten den Eingängen eines I/Q-Modulators 2 zugeführt. An einem dritten Eingang wird dem I/Q-Modulator 2 ein Oszillator-Signal zugeführt, welches von dem zweiten Oszillator 13 erzeugt wird.

Das I/Q-modulierte Signal wird in einen ersten Mischer 3 an seinem ersten Eingang eingespeist. An einem zweiten Eingang wird in den Mischer 3 ein Signal mit variabler Frequenz aus einem Synthesizer 10, z.B. einer PLL (phaselocked-loop), eingespeist, welche von einem dritten Oszillator 14 als Referenzsignal abgeleitet ist. Das Signal aus dem Mischer 3 wird an einem ersten Eingang des Mischers 4 eingespeist. An einem zweiten Eingang des Mischers 4 wird ein Signal eingespeist, welche von einem vierten Oszillator 15 abgeleitet ist.

Das Ausgangs-Signal aus dem zweiten Mischer 4 wird einem Umschalter 6 an einem ersten Eingang zugeführt. Das Ausgangs-Signal aus dem ersten Mischer 3 wird dem Umschalter 6 über eine Verbindung 5 an einem zweiten Eingang zugeführt. Der Umschalter 6 ist mit dem Ausgang 7 der Schaltung zur Signalaufbereitung verbunden.

In der dargestellten Konfiguration weist das in den Digital/Analog-Wandler eingespeiste Basisbandsignal eine Bandbreite von 0 bis 40 MHz auf. Dies gilt jeweils für den I- und Q-Kanal des in die Schaltung zur Signalaufbereitung eingespeisten Basisbandsignals. Dem Digital/Analog-Wandler 1 wird ein Taktsignal von 400 MHz zugeführt.

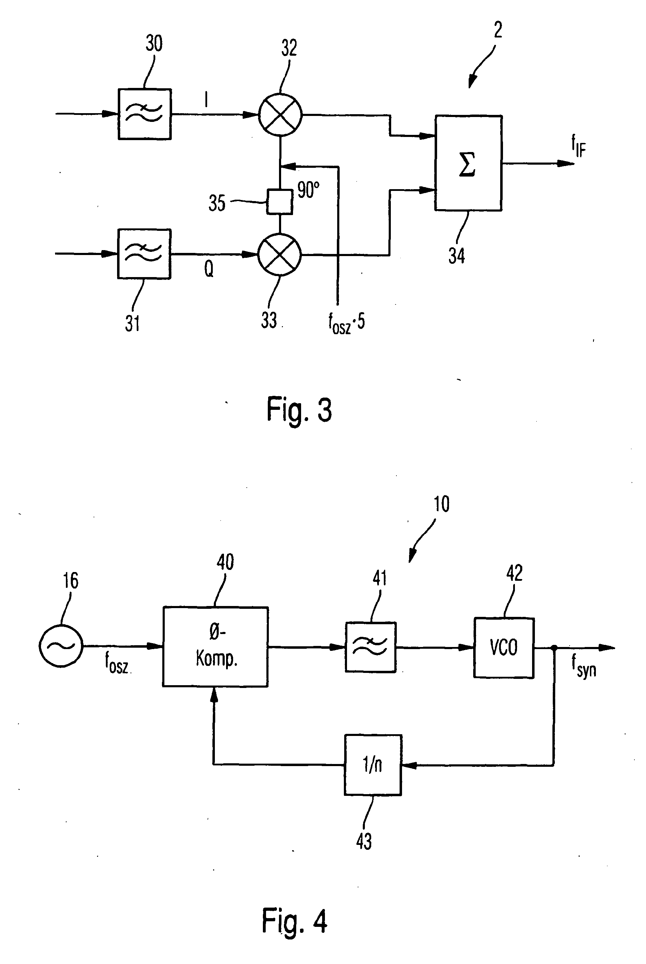

Die analogen I- und Q-Kanäle am Ausgang des Digital/Analog-Wandlers 1 werden jeweils dem I/Q-Modulator 2 zugeführt. Nach der Digital/Analog-Wandlung in der Stufe 21 besitzt das Signal in der dargestellten Ausführung in Fig. 3 eine Bandbreite zwischen 60 und 140 MHz. Nach der I/Q-Modulation mit dem I/Q-Modulator 2 in der Stufe 22 und der gleichzeitigen Anhebung in den Zwischenfrequenzbereich von 4 GHz liegt das Signal um Frequenzen von 3,86 und 3,94 GHz. Mittels des ersten Mischers 3 in der ersten Mischerstufe 23 wird das so modulierte Signal über einen Signal- oder Frequenzsynthesizer 10 in den Frequenzbereich von 0,1 bis 3,3 GHz gemischt. Dieses Signal kann über eine Leitung 5 und den Umschalter 6 direkt mit dem Ausgang 7 verbunden werden. In einer weiteren Mischerstufe 24 mit dem zweiten Mischer 4 kann das Signal weiter umgesetzt werden. In der Darstellung wird der Mischerstufe 4 ein Oszillator-Signal einer Frequenz von 6,4 GHz zugeführt.

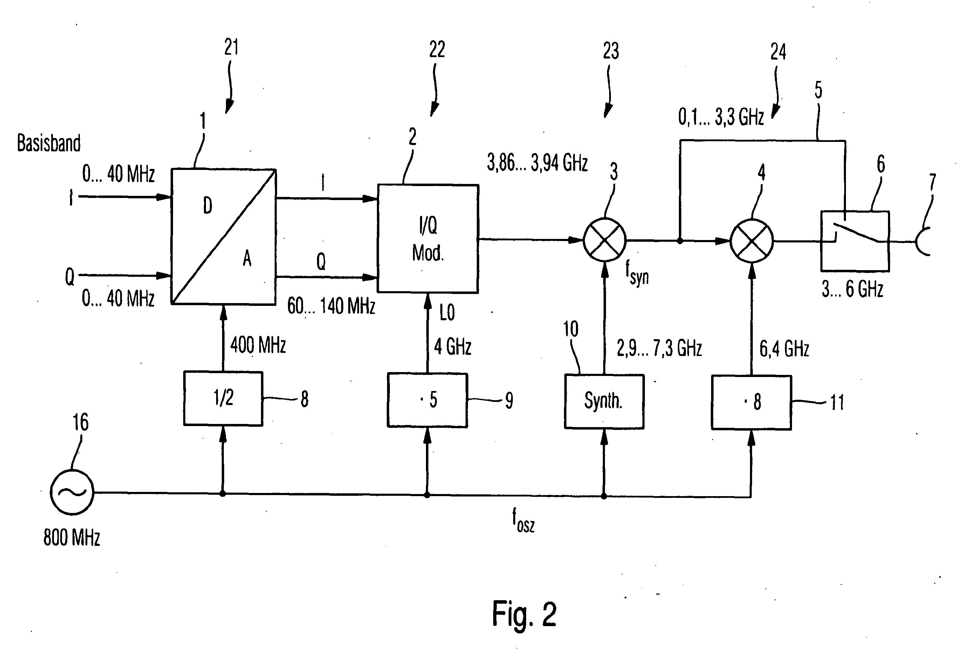

Eine veränderte Schaltungsanordnung gemäß der Erfindung ist in Fig. 2 dargestellt. Dieses besteht im wesentlichen aus den gleichen Komponenten wie die Schaltung in Fig. 1. Die Komponenten wurden zur besseren Übersichtlichkeit mit der gleichen Bezugszeichen versehen.

In der Schaltungsanordnung der Fig. 2 finden sich so ebenfalls ein Digital/Analog-Wandler 1, ein I/Q-Modulator 2, die Mischer 3 und 4, die Verbindung 5 sowie ein Umschalter 6. Über die Verbindung 5 kann das Ausgangssignal des Mischers 3 auch direkt, über den Umschalter 6, an den Ausgang 7 gegeben werden.

Die Schaltungsanordnung enthält einen Frequenzteiler 8, Frequenzvervielfacher 9 und 11, sowie den Frequenzsynthesizer 10. Die Verschaltung der Komponenten in Fig. 2, sowie deren Funktion ist im wesentlichen die gleiche wie in Fig. 1. Erfindungsgemäß wird jedoch im Unterschied zur Schaltung nach der Fig. 3 dem Frequenzteiler 8, den Frequenzvervielfachern 9 und 11, sowie dem Frequenzsynthesizer 10 an deren Eingängen das Signal nur eines gemeinsamen Oszillators 16 zugeführt.

Durch die Nutzung dieses einzelnen Oszillators 16, dessen Signal den einzelnen Stufen 21-24 zugeführt wird, sind die Phasenfluktuationen der auftretenden Oszillatorsignale und somit auch der Ausgangs-Signale der einzelnen Stufen 21-24 korreliert, sodass durch die bestehende Korrelation das Gesamtrauschen der Schaltungsanordnung im Vergleich zu Fig. 1 vermindert wird. Durch den Frequenzteiler 8 und die Frequenzvervielfacher 9 und 11 wird die Verwendung eines gemeinsamen Oszillatorsignals des Oszillators 16 ermöglicht.

Zum besseren Verständnis der Schaltungsanordnungen zur mehrstufigen Signalaufbereitung gemäß der Erfindung in Fig. 2 werden nachfolgend anhand der Figuren 3 und 4 die Funktionsweise eines I/Q-Modulator und eines Frequenzsynthesizers erklärt.

Fig. 3 zeigt einen üblichen I/Q-Modulator 2, der in Fig. 2 verwendet wird. Der I- und Q- Anteil eines komplexen Basisband-Signales wird über Tiefpässe 30, 31 ein Paar von Mischern 32, 33 und einen Addierer 34 in eine Zwischenfrequenzlage f_{IF} umgesetzt. Dazu wird zusätzlich ein Oszillatorsignal 5·fosz dem I/Q-Modulator zugeführt, wobei dieses Oszillatorsignal einem der Mischer 32 direkt und dem anderen Mischer 33 über einen 90°-Phasenschieber zugeführt wird. Zunächst werden der I und Q Anteil tiefpaßgefiltert um mögliche Oberwellen oder Harmonische des D/A-Wandlers 1 zu beseitigen.

Fig. 4 zeigt einen üblichen Frequenzsynthesizer 10, wie er bei der Schaltung nach Fig. 2 verwendet werden kann. Ein Phasenkomparator erhält als ein erstes Eingangssignal die Referenzfrequenz f_{osz}. Diese Referenzfrequenz wird mit einem Signal aus einem variablen Frequenzteiler 43 mit dem Teilfaktor 1/n verglichen. Am Ausgang des Phasenkomparators 40 wird ein Regelsignal ausgegeben, welches über den Tiefpaß 41 integriert an den spannungsgesteuerten Oszillator, 42 weitergegeben wird. Meist werden in dem spannungsgesteuerten Oszillator Schwingkreise mit Kapazitätsdioden verwendet. Die Kapazitätsdioden weisen je nach Eingangsspannung eine variable Kapazität auf. Somit kann die Resonanzfrequenz des Schwingkreises je nach Eingangsspannung variiert werden.

Die Erfindung ist nicht auf die beschriebenen Ausführungsbeispiele beschränkt. Die erfindungsgemäße Schaltungsanordnung zur Signalaufbereitung kann vielfältig zum Einsatz kommen.

## Patentansprüche

1. Schaltung zur Signalaufbereitung bestehend aus einer ersten Stufe (21) mit einem Digital/Analog-Wandler (1),
einer zweiten Stufe (22) mit einem I/Q-Modulator (2) und zumindest einer dritten Stufe (23) mit einem ersten Mischer (3),
wobei eine vierte Stufe (24) einen zweiten Mischer (4) enthält,
wobei die zweite Stufe (22) mit dem I/Q-Modulator (2) der ersten Stufe (21) mit dem Digital/Analog-Wandler (1) nachgeschaltet ist,
wobei statt einer Vielfachheit von unabhängigen Oszillatoren (12,13,14,15) für die einzelnen Stufen (21,22,23,24) ein gemeinsamer Oszillator (16) vorhanden ist, von dessen Ausgangssignal das jeweilige Oszillator- bzw. Taktsignal für die jeweilige Stufe (21, 22, 23, 24) abgeleitet ist,
wobei das Oszillator- bzw. Taktsignal des Oszillators (16) über einen Frequenzteiler (8) zumindest einer Stufe (21) zugeführt ist oder dass das Oszillatorsignal des Oszillators (16) über einen Frequenzvervielfacher (9;11) zumindest einer Stufe (22,24) zugeführt ist,
wobei das Oszillatorsignal des Oszillators (16) als Referenzsignal einem Frequenzsynthesizer (10) zumindest einer Stufe (23) zugeführt ist,
und wobei das Ausgangs-Signal aus dem zweiten Mischer (4) einem Umschalter (6) an einem ersten Eingang zugeführt ist und das Ausgangs-Signal aus dem ersten Mischer (3) dem Umschalter (6) über eine Verbindung (5) an einem zweiten Eingang zugeführt ist und der Umschalter (6) mit dem Ausgang (7) der Schaltung zur Signalaufbereitung verbunden ist.

## Claims

1. A circuit for signal conditioning comprising a first stage (21) with a digital/analog converter (1), a second stage (22) with an I/Q-modulator (2) and at least one third stage (23) with a first mixer (3),
wherein a fourth stage (24) contains a second mixer (4), wherein the second stage (22) with the I/Q modulator (2) is connected downstream of the first stage (21) with the digital/analog converter (1),
wherein, instead of a multiplicity of independent oscillators (12, 13, 14, 15) for the individual stages (21, 22, 23, 24), a shared oscillator (16) is provided, from the output signal of which the respective oscillator signal or clock-pulse signal for the respective stage (21, 22, 23, 24) is derived,
wherein the oscillator signal or clock-pulse signal of the oscillator (16) is supplied via a frequency divider (8) to at least one stage (21) or that the oscillator signal of the oscillator (16) is supplied via a frequency multiplier (9; 11) to at least one stage (22, 24),
wherein the oscillator signal of the oscillator (16) is supplied as a reference signal to a frequency synthesiser (10) of at least one stage (23),
and wherein the output signal is supplied from the second mixer (4) to a changeover switch (6) at a first input, and the output signal from the first mixer (3) is supplied to the changeover switch (6) via a connection (5) at a second input, and the changeover switch (6) is connected to the output (7) of the circuit for signal conditioning.

## Revendications

1. Circuit de traitement de signal constitué d'un premier étage (21) avec un convertisseur analogique/numérique (1), d'un deuxième étage (22) avec un modulateur I/Q (2) et au moins d'un troisième étage (23) avec un premier mélangeur (3),
un quatrième étage (24) comprenant un deuxième mélangeur (4),
le deuxième étage (22) avec le modulateur I/Q (2) étant situé en aval du premier étage (21) avec le convertisseur analogique/numérique (1),
un oscillateur commun (16) étant présenté au lieu d'une pluralité d'oscillateurs indépendants (12, 13, 14, 15) pour les différents étages (21, 22, 23, 24), le signal d'oscillateur ou d'horloge pour chaque étage (21, 22, 23, 24) étant dérivé du signal de sortie de celui-ci,
le signal d'oscillateur ou d'horloge de l'oscillateur (16) étant acheminé vers au moins un étage (21) par l'intermédiaire d'un diviseur de fréquence (8), ou le signal d'oscillateur de l'oscillateur (16) étant acheminé vers au moins un étage (22, 24) par l'intermédiaire d'un multiplicateur de fréquence (9 ; 11),
le signal d'oscillateur de l'oscillateur (16) étant acheminé vers au moins un étage (23) en tant que signal de référence d'un synthétiseur de fréquence (10),
et le signal de sortie du deuxième mélangeur (4) étant acheminé vers un commutateur (6) sur une première entrée, et le signal de sortie du premier mélangeur (3) étant acheminé vers le commutateur (6) par l'intermédiaire d'une connexion (5) sur une deuxième entrée, et le commutateur (6) étant relié à la sortie (7) du circuit de traitement de signal.
